(19) Europäisches Patentamt
European Patent Office
Office européen des brevets

(11) Publication number: **0 503 164 A1**

# (12) EUROPEAN PATENT APPLICATION

(21) Application number: **91200518.8**

(22) Date of filing: **11.03.91**

(51) Int. Cl.[5]: **G03C 8/36**, G03C 8/06, G03F 7/07

(43) Date of publication of application:
**16.09.92 Bulletin 92/38**

(84) Designated Contracting States:
**AT BE CH DE DK ES FR GB GR LI LU NL SE**

(71) Applicant: **AGFA-GEVAERT naamloze vennootschap**
**Septestraat 27**
**B-2640 Mortsel(BE)**

(72) Inventor: **Vaes, Jos Alfons**
**Moorsemsestraat 245**
**B-3130 Betekom(BE)**
Inventor: **Berendsen, Jules Robert**
**Drakenhoflaan 162-4**
**B-2100 Deurne(BE)**
Inventor: **Vandenbruwaene, Rik Bernard**
**Kopkapelstraat 31**
**B-9160 Lokeren(BE)**

## (54) Activator solution for DTR-process.

(57) The present invention provides a fresh activating liquid for developing a silver salt diffusion transfer (DTR) material. Said fresh activating liquid comprises a p-dihydroxybenzene derivative in an amount of $10^{-4}$ mol/l to $5*10^{-2}$mol/l. Developing a DTR material by means of such an activating liquid results in a more uniform development which also results in a higher printing endurance when said DTR material is used as a printing plate. According to the present invention there is also provided a method for producing a lithographic printing plate by developing a DTR material using said activating liquid.

EP 0 503 164 A1

1. Field of the invention.

The present invention relates to a method for producing a lithographic printing plate by the silver complex diffusion transfer process and a processing solution for use in said diffusion transfer process.

2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. For example, typical lithographic printing plates are disclosed e.g. in Japanese Examined Patent Publication (Kokoku) 30562/73, Japanese Unexamined Patent Publications (Kokai) Nos. 21602/78, 103104/79, 9750/81 etc.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method. Thus, it is known e.g. from the United Kingdom Patent Specification 1,241,661 to produce a planographic printing plate consisting of a sheet material comprising an outer hydrophilic colloid layer on the surface of which there is concentrated a silver image stemming from an underlying exposed silver halide emulsion layer by the silver complex diffusion transfer reversal process.

According to a well known conventional embodiment the silver halide emulsion contained in the DTR element is orthochromatically sensitized with a conventional cyanine or merocyanine dye so that said DTR element can be exposed on a process camera using an ordinary light source, e.g. tungsten light. Commercially available DTR materials according to this conventional method which can be processed to lithographic printing plates are marketed e.g. by MITSUBISHI PAPER MILLS LTD under the trade name SILVERMASTER and by AGFA-GEVAERT N.V. under the trade name SUPERMASTER.

According to more recent developments new types of DTR elements are used as recording materials for phototype-setting and image-setting devices which employ laser beams as their output energy source. According to these so-called "direct to plate" methods these laser-exposed DTR materials are transformed in direct-to-use printing plates containing type- and image information, thus avoiding the intermediate steps as in conventional pre-press work flow.

As a consequence these DTR elements must show a spectral sensitivity matching as closely as possible the emission wavelength of the laser beam in question.

For example, lithographic DTR elements suited for exposure by helium-neon laser (HeNe) or light emitting diode (LED), both devices emitting in the red region of the visual spectrum, are disclosed in US-P 4,501,811 and Japanese Unexamined Patent Publication (Kokai) Nos. 71055/84 and 75838/85. A commercially available DTR material spectrally sensitized for HeNe exposure is marketed by AGFA-GEVAERT N.V. under the trade name SETPRINT HeNe-plate PP 410 p.

On the other hand semiconductor lasers, also called laserdiodes, show some advantages compared to other laser types such as low cost price, small size and long life time. Generally the emission wavelength of these semiconductor laser beams is longer than 700 nm and mostly longer than 750 nm. A commercial image-setter using infra-red laserdiode source was announced by XENOTRON Co in "Ifra Newspaper Techniques" No 7 (oct. 1985) p. 27. Photographic materials appropriate for exposure by devices employing such laserdiodes must be sensitized for the near infra-red region of the radiation spectrum. Suitable photographic materials to be used with semiconductor laser device are disclosed in Japanese Unexamined Patent Publication (Kokai) No 61752/85 and US-P 4,784,933. Commercial infra-red sensitized phototypesetting film and paper were announced by EASTMAN KODAK Co in "Proceedings Lasers in Graphics,

Electronic Publishing in the 80's", Vol. 2 (sept. 1985) p. 508.

The developing agent or a mixture of developing agents used for developing an information-wise exposed DTR-element can be present in an alkaline processing solution and/or in the DTR-element itself. In case the developing agent or a mixture of developing agents is contained in the DTR-element, the processing solution can be merely an aqueous alkaline solution, substantially free of developing agents, that initiates and activates the development, such alkaline solution being referred to hereinafter as "activator solution". On the other hand the expressions "developing solution" and "development type DTR element" as used herinafter are meant as being restricted to "solutions containing developing agents" and "DTR element to be developed with a solution containing developing agents".

The developing and/or activator solution preferably also contains a silver halide solvent. Preferred silver halide solvents are watersoluble thiosulphate compounds such as ammonium and sodium thiosulphate, or ammonium and alkali metal thiocyanates. Other useful silver halide solvents (or "complexing agents") are described in the book "The Theory of the Photographic Process" edited by T.H. James, 4th edition, p. 474-475 (1977), in particular sulphites and uracil. Further interesting silver halide complexing agents are cyclic imides, preferably combined with alkanolamines, as described in US-P 4,297,430 and US-P 4,355,090. 2-mercaptobenzoic acid derivatives are described as silver halide solvents in US-P 4,297,429, preferably combined with alkanolamines or with cyclic imides and alkanolamines.

Usually when a photographic DTR-material is intended to serve as lithographic printing plate the developing or activator solution is followed by a so-called neutralization solution containing buffer substances to neutralize the alkaline DTR-material after treatment with the developer or activator bath.

The use of an activator solution is preferred for ecological reasons and convenience. However the printing characteristics of a lithographic printing plate obtained by the processing of a DTR element with an activator solution are inferior to the characteristics of a lithographic printing plate obtained by processing with a developing solution. It was found that a DTR element processed with an activator solution showed areas which were less developed then others which resulted in a reduced printing endurance with respect to a DTR element processed with a developer. These difference between the processing of a DTR element with a developer and activator are especially pronounced when a fresh activator solution is used. The wording "fresh activator solution" is used to indicate that no DTR-materials have been processed before in said solution.

3. Summary of the invention.

It is an object of the present invention to provide a method for producing a lithographic printing plate of high printing endurance by the processing of a silver salt diffusion transfer material with an activator solution.

It is also an object of the present invention to provide an activator solution for processing a silver salt diffusion transfer material.

Other objects of the present invention will become clear from the description hereinafter.

According to the present invention a fresh activator solution is provided comprising a p-dihydroxybenzene derivative in an amount from $10^{-4}$ mol/l to $5*10^{-2}$ mol/l.

According to the present invention a method is provided for producing a lithographic printing plate by the processing of a silver salt diffusion transfer material with a fresh activator solution comprising a p-dihydroxybenzene derivative in an amount from $10^{-4}$ mol/l to $5*10^{-2}$ mol/l.

3. Detailed description of the invention.

According to the present invention it has been found that when a p-dihydroxybenzene derivative is comprised in a fresh activator solution in small amounts i.e. from $10^{-4}$ mol/l to $5*10^{-2}$ mol/l a uniform development of a DTR material can be obtained. When said DTR material is used as a lithographic printing plate a printing endurance comparable to a DTR material processed with a developer was found. Although p-dihydroxybenzene derivatives are known as developing agents, the amounts employed in the fresh activator solution for use in accordance with the present invention are to low to cause development of a DTR material not comprising additional developing agents. When the total concentration of p-dihydroxybenzene derivative(s) used is lower than $10^{-4}$ mol/l no or only a small improvement was noticed whereas the maximum improvement is obtained around $5*10^{-2}$ mol/l. Suitable p-dihydroxybenzene derivatives for use in accordance with the present invention are e.g. hydroquinone, a hydroquinone monosulfonate salt, methylhydroquinone, chlorohydroquinone etc.

According to the present invention the fresh activator solution can contain as silver halide complexing

agent a thiocyanate compound, e.g. alkali thiocyanate or ammonium thiocyanate, or a thiosulphate compound, e.g. sodium or ammonium thiosulphate, or a mixture of thiosulphate and thiocyanate. Further interesting silver halide complexing agents, preferred in the present invention, are cyclic imides, preferably combined with alkanolamines, as described in US-P 4,297,430 and US-P 4,355,090 and 2-mercaptobenzoic acid derivatives as described in US-P 4,297,429, preferably combined with alkanolamines or with cyclic imides and alkanolamines.

The fresh activator solution preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

The fresh activator solution can contain one or more hydrophobizing agents to enhance the ink-receptive properties of the DTR silver image, e.g. those described in US-P 3,776,728, and US-P 4,563,410. Preferred compounds are
5-n-heptyl-2-mercapto-1,3,4,-oxadiazol and
3-mercapto-4-acetamido-5-n.heptyl-1,2,4-triazole.

Further an inorganic alkali agent, e.g. sodium hydroxide is present in the fresh activator solution to establish a pH value ranging from 12 to 14, preferably at least 12.5. Other alkali agents can be included e.g. secondary and/or tertiary alkanolamines.

Finally, to assure a good spread, the activator solution can contain wetting agents, preferably compounds containing perfluorinated alkyl groups.

According to the method of the present invention an image-wise exposed DTR element is processed in an activator solution having a composition as described above. The development and diffusion transfer can be initiated in different ways e.g. by rubbing with a roller that has been wetted with the processing liquid, e.g. acts as meniscus coater, by wiping with an absorbent means e.g. with a plug of cotton or sponge, or by dipping the material to be treated in the liquid composition. Preferably, they proceed in an automatically operated apparatus such as RAPILINE SP 430, marketed by AGFA. The DTR-process is normally carried out at a temperature in the range of 10°C to 35°C. In order to minimize the quality loss due to bath exhaustion, regenerating liquids can be added in proportion to the consumption of processing liquids. Preferably the DTR material is subsequently guided through a neutralization solution. In order to reduce the pH of the wet swollen DTR element leaving the alkaline activator solution, the neutralization liquid contains buffer ions, e.g. phosphate buffer or citrate buffer to establish in said liquid a pH value ranging from 5.0 to 7.0. The neutralization solution can further contain bactericides, e.g. phenol, thymol or 5-bromo-5-nitro-1,3-dioxan as described in European Patent Specification EP 0,150,517. The liquid can also contain substances which influence the hydrophobic / hydrophilic balance of the printing plate obtained after processing of the DTR element, e.g. silica. Finally the neutralization solution can contain wetting agents, preferably compouds containing perfluorinated alkyl groups.

The photographic DTR mono-sheet element for use in accordance with the present invention contains at least one silver halide emulsion layer and a development nuclei containing image-receiving surface layer but other hydrophilic layers may be present such as a hydrophilic layer intermediate between the support and the emulsion layer, a hydrophilic layer between the emulsion layer and the image-receiving layer, and a backing layer applied at the non light-sensitive side of the support.

The photographic emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially

all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 µm , preferably from 0.25 to 0.45 µm.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $10^{-7}$ and $10^{-6}$ mole per mole of $AgNO_3$. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, holopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. A preferred green sensitizing dye in connection with the present invention is represented by the following chemical formula :

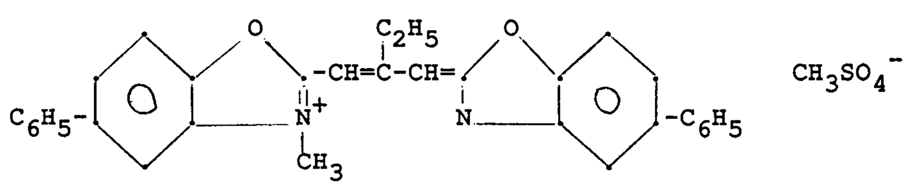

(1)

In case of exposure by a red light emitting source, e.g. a LED or a HeNe laser a red sensitizing dye is used. A preferred red sensitizing dye is :

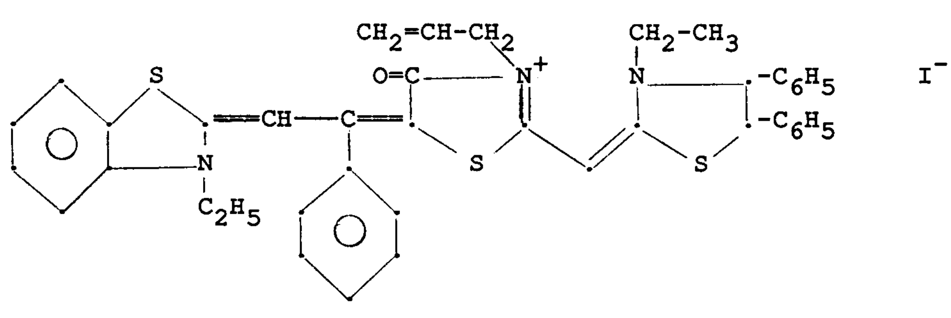

(2)

In case of exposure by an argon ion laser a blue sensizing dye is incorporated. A preferred blue sensitizing dye is represented by :

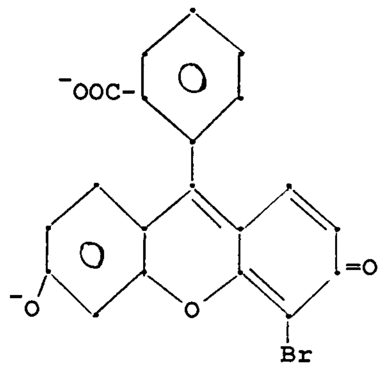

2 $Na^+$

(3)

In case of exposure by a semiconductor laser special spectral sensitizing dyes suited for the near infra-red are required. Suitable infra-red sensitizing dyes are disclosed in i.a US-P Nos 2,095,854, 2,095,856, 2,955,939, 3,482,978, 3,552,974, 3,573,921, 3,582,344, 3,623,881 and 3,695,888. A preferred infra-red sensitizing dye is :

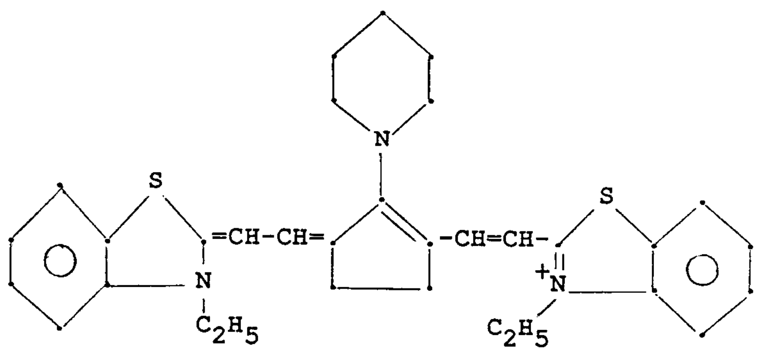

$Br^-$

(4)

To enhance the sensitivity in the near infra-red region use can be made of so-called supersensitizers in combination with infra-red sensitizing dyes. Suitable supersensitizers are described in Research Disclosure Vol 289, May 1988, item 28952. A preferred supersensitizer is Compound IV of the Disclosure having following formula :

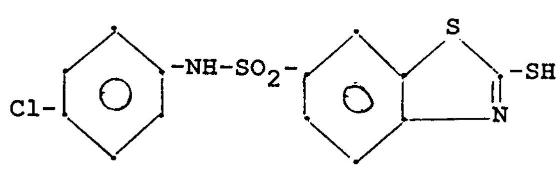

(5)

The spectral sensitizers can be added to the photographic emulsions in the form of an aqeous solution, a solution in an organic solvent or in the form of a dispersion.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other

suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787, DE-P 2,453,217, and GB-P 7,907,440.

The silver halide developing agent used in the DTR mono-sheet element according to the present invention is preferably a p-dihydroxybenzene compound, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. The ratio of the amount of (a) p-dihydroxybenzene compound(s) to the amount of phenidone type compounds is preferably not higher than 2.5. However in order to take most advantage of the present invention said ratio is preferably not higher than 2.0 and in a still more preferred embodiment said ratio is comprised between 2.0 and 0.8.

The p-dihydroxybenzene compound(s) and the phenidone type compound(s) used in accordance with the present invention can be present in any of the layers on the light-sensitive side of the support or can be distributed over those layers in any ratio. The total amount of the p-dihydroxybenzene compound(s) is preferably comprised between 0.25 and 0.75 $g/m^2$. In a preferred embodiment the p-dihydroxybenzene compound(s) is (are) distributed between the emulsion layer and the nuclei containing image-receiving layer. The total amount of the phenidone type compound(s) is preferably comprised between 0.10 and 0.75 $g/m^2$. In a preferred embodiment the phenidone type compound(s) is (are) distributed between the emulsion layer and the antihalation layer, present between the support and the emulsion layer. The developing agents can be added to the photographic material in the form of aqueous solutions or dispersions.

Development acceleration can be accomplished with the aid of various compounds, preferably polyalkylene derivatives having a molecular weight of at least 400 such as those described in e.g. US-P 3,038,805 - 4,038,075 - 4,292,400.

In an especially preferred embodiment the emulsion layer contains a compound which comprises in its molecular structure a group capable of adsorbing to silver halide and a group capable of reducing silver halide. Compounds of this kind have been disclosed in the European Patent Application, filed on 26.02.90 under application No 90.200458.9. In this way a combination of a stabilizing and a development activating function in one compound is achieved. A preferred compound belonging to this class is represented by the following formula :

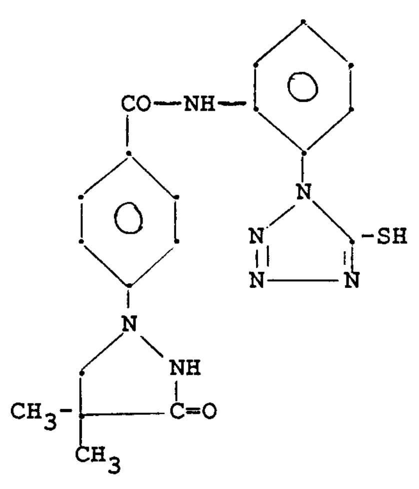

More details about the composition, preparation and coating of silver halide emulsions can be found in e.g. Product Licensing Index, Vol. 92, December 1971, publication 9232, p. 107-109.

In a preferred embodiment in connection with the present invention a backing layer is provided at the non-light sensitive side of the support. This layer which can serve as anti-curl layer can contain i.a. matting

agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichioro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

In a preferred embodiment of the present invention an intermediate hydrophilic layer, serving as antihalation layer, is provided between the support and the silver halide emulsion layer. This layer can contain the same light-absorbing dyes as described above for the emulsion layer ; as alternative finely divided carbon black can be used for the same antihalation purposes as described in US-P 2,327,828. On the other hand, in order to gain sensitivity, light reflecting pigments,e.g. titaniumdioxide can be present. Further this layer can contain hardening agents, matting agents, e.g. silica particles, and wetting agents.

The photographic element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic element of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy-(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The support of the DIR mono-sheet material may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a subbing layer which can contain water insoluble particles such as silica or titanium dioxide.

In the image receiving layer, preferred development nuclei are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable

development nuclei are salts such as e.g. selenides, polyselenides, polysulphides, mercaptans, and tin (II) halides. Heavy metals, preferably silver, gold, platinum, palladium, and mercury can be used in colloidal form.

The DTR mono-sheet material in connection with the present invention is exposed in an apparatus according to its particular application, e.g. a conventional process camera containing a conventional light source or a laser containing device. Examples of HeNe laser containing exposure units are the image-setters LINOTRONIC 300, marketed by LINOTYPE Co, and CG 9600, marketed by AGFA COMPUGRAPHIC, a division of AGFA CORPORATION. An image-setter provided with an Ar ion laser is LS 210, marketed by Dr-Ing RUDOLF HELL GmbH. Exposure units provided with a laserdiode are LINOTRONIC 200, marketed by LINOTYPE Co, and CG 9400, marketed by AGFA COMPUGRAPHIC, a division of AGFA CORPORATION.

The following examples illustrate the present invention without however, limiting it thereby. All parts, percentages and ratios are by weight unless otherwise indicated.

EXAMPLE 1

A gelatino silver halide emulsion was prepared by double jet precipitation by slowly mixing with stirring an aqueous solution of $AgNO_3$ having a concentration of 2 mole/l, and an aqueous solution having a concentration of 1.7 mole/l of NaCl, 0.48 mole/l of KBr and 0.001 mole/l of KI. Before the precipitation $5.10^{-4}$ mole/l of sodium hexachlororhodaat was added to the silver nitrate solution. In a second part of the precipitation an aqueous solution of $AgNO_3$ having a concentration of 1 mole/l was slowly mixed with an aqueous solution of NaCl at a concentration of 1.3 mole/l.

The temperature during the silver halide formation was 55 °C.

The obtained core-shell emulsion was cooled, flocculated and washed. Gelatin was added in an amount sufficient to reach a ratio of 2/3 by weight of gelatin to silver halide, expressed as equivalent amount of silver nitrate.

Subsequently a chemical ripening was carried out in a conventional way known to those skilled in the art using thiosulphate and gold salts.

Finally the emulsion was sensitized for the red spectral region by using Compound (2) mentioned in the description.

A photographic DTR mono-sheet material was prepared as follows. One side of a paper support weighting 135 g/$m^2$ and coated on both sides with polyethylene was subjected to corona discharge and then coated with two layers by a double layer coating technique the layer nearer to the support being the antihalation layer and the other being the emulsion layer. The emulsion was coated at an amount of silver halide corresponding to 1.5 g $AgNO_3$ /$m^2$. This emulsion layer contained 0.1 g/$m^2$ of 1-phenyl-3-pyrazolidinone and 1.0 g/$m^2$ of gelatin.

The antihalation layer contained carbon black, silica particles of 5 micron average size and gelatin at 3 g/$m^2$. The gelatin was lime treated and substantially free of calcium ions (1000 ppm or less).

After drying these layers were subjected to a temperature of 40 °C for 5 days and then overcoated with a layer containing PdS nuclei, hydroquinone at 0.4 g/$m^2$ and formaldehyde at 100 mg/$m^2$.

The following processing solutions were prepared :

| Fresh activator solutions | | | |
|---|---|---|---|
| | A | B | C |
| hydroquinone monosulfonate potassium salt (g) | - | 1 | 10 |
| sodium hydroxide (g) | 30 | id | id |
| sodium sulphite anh. (g) | 33 | id | id |
| potassium thiocyanate (g) | 20 | id | id |
| 3-mercapto-4-acetamido-5-n.heptyl-1,2,4-triazole (g) | 0.15 | id | id |
| water to make | 11 | id | id |
| A is a comparitive activator solution, B and C are according to the invention. | | | |

| Neutralization solution | |
|---|---|
| citric acid | 10 g |
| sodium citrate | 35 g |
| cysteine | 1 g |
| sodium sulphite anh. | 5 g |
| phenol | 50 mg |
| water to make | 11 |

| Dampening solution | |
|---|---|
| water | 880 ml |
| citric acid | 6g |
| boric acid | 8.4g |
| sodium sulphate anh. | 25g |
| ethyleneglycol | 100g |
| colloidal silica | 28g |

Each of 3 DTR materials as described above were image-wise exposed in the HeNe laser containing image-setter CG 9600, marketed by AGFA COMPUGRAPHIC, a division of AGFA CORPORATION, were subsequently treated with one of the 3 described fresh activator solutions for 10 seconds at 30 °C, thereupon treated with the described neutralization solution at 25 °C and finally dried.

Each of the 3 printing plates thus prepared were mounted on an offset printing machine ( AB Dick 9860 CD - trade name for offset printing machine manufactured by AB DICK Co). During the printing run the described dampening solution was used in each case.

The sensitometric properties of this material were characterized by the maximal transmission density and the uniformity of the development.

The lithographic properties printing endurance was evaluated as the number of printed copies before disappearance of ink in the ink accepting areas begins to occur. Table 1 represents the results for each of the 3 printing plates obtained with the 3 activator solutions A, B and C.

Table 1

| activator | $D_{TR}$ | uniformity | printing end. |
|---|---|---|---|
| A | 1.66 | very bad | <100 |
| B | 1.77 | good | 10.000 |
| C | 1.81 | good | 10.000 |

EXAMPLE 2

The emulsion of example 1 was sensitized for wavelengths above 700nm instead of for the red spectral region with a supersensitizing mixture of compound 4 and Compound 5 mentioned in the description. Similar results as presented in example 1 were obtained when thus prepared DTR-materials were image-wise exposed to a laserdiode phototypesetter CG 9400, marketed by AGFA COMPUGRAPHIC, a division of AGFA CORPORATION and processed with the 3 fresh activator solutions presented in example 1.

EXAMPLE 3

3 DTR monosheet materials were prepared as follows. One side of a transparent polyethyleneterephtalate support was coated with a pack of two backing layers, the other side was coated with an antihalation layer and an emulsion layer. After drying these layers were subjected to a temperature of 40 °C for 5 days and then the emulsion layer was overcoated with a layer containing development nuclei.

The layer nearest to the support of the backing layer pack contained 0.3 g/$m^2$ of gelatin and 0.5 g/$m^2$ of the antistatic agent co(tetraallyloxyethane / methacrylate / acrylic acid-K-salt) polymer. The second backing

layer contained 4 g/m$^2$ of gelatin, 0.15 g/m$^2$ of a matting agent consisting of transparent spherical polymeric beads of 3 micron average diameter according to EP 0080225, 0.05 g/m$^2$ of hardening agent triacrylformal and 0.021 g/m$^2$ of wetting agent $F_{15}C_7$-$COONH_4$.

The antihalation layer contained 0.1 g/m$^2$ of carbon black, 3 g/m$^2$ of gelatin and 0.8 g/m$^2$ of silica particles of 5 micron average diameter.

The emulsion was a typical chlorobromide emulsion composed of 98.2 % of chloride and 1.8 % of bromide, having an average grain size of 0.4 micron and containing Rhodium ions as internal dopant. The emulsion was orthochromatically sensitized by means of compound 1 mentioned in the description above.

The emulsion was stabilized by a mixture of 1-phenyl-5-mercaptotetrazole and a compound according to following formula :

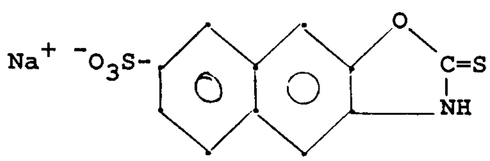

The emulsion layer contained 1.5 g/m$^2$ of silver halide expressed as $AgNO_3$, 0.15 g/m$^2$ of 1-phenyl-4,4'-dimethyl-3-pyrazolidinone ("dimethyl-Phenidone"; DMP), 0.25 g/m$^2$ of hydroquinone (HQ) and 1.5 g/m$^2$ of gelatin.

The nuclei containing layer contained PdS nuclei, hydroquinone at 0.4 g/m$^2$ and formaldehyde at 100 mg/m$^2$.

The thus prepared DTR-materials were image-wise exposed and the 3 DTR-materials were processed with a fresh activator solution A, B or C and subsequently neutralized at 25 °C with the neutralization solution described in example 1 and subsequently dried. The thus obtained lithographic printing plates were used to print as described in example 1. The results are represented in table 2.

Table 2

| activator | $D_{TR}$ | uniformity printing end. | |
|---|---|---|---|
| A | 1.65 | bad | 11.000 |
| B | 1.73 | good | 13.000 |
| C | 1.81 | good | 14.000 |

## Claims

1. A fresh activator solution comprising a silver halide solvent and an alkali agent characterized in that said fresh activator solution comprises (a) p-dihydroxybenzene derivative(s) in a total amount of $10^{-4}$ mol/l to $5*10^{-2}$ mol/l.

2. A fresh activator solution according to claim 1 wherein said p-dihydroxybenzene derivative is hydroquinone or a hydroquinone monosulfonate salt.

3. A method for producing a lithographic printing plate by the silver salt diffusion transfer process comprising the steps of image wise exposing a DTR-element comprising on a support a silver halide emulsion layer, an image receiving layer and one or more developing agents and developing said image wise exposed DTR element characterized in that said development is done by means of a fresh activator solution comprising (a) p-dihydroxybenzene derivative(s) in a total amount of $10^{-4}$ mol/l to $5*10^{-2}$ mol/l.

4. A method according to claim 3 wherein said p-dihydroxybenzene derivative is hydroquinone or hydroquinone monosulfonate.

5. A method according to claims 3 or 4 wherein two types of developing agents are comprised in said DTR-element one of said developing agents being of the p-dihydroxybenzene type and the other being

of the 1-phenyl-3-pyrazolidinone type.

**6.** A method according to claim 5 wherein said developing agents of the p-dihydroxybenzene type are comprised in a total amount of 0.25g/$m^2$ and 0.75g/$m^2$ in said DTR-element and said developing agents of the 1-phenyl-3-pyrazolidinone type are comprised in a total amount of 0.1g/$m^2$ to 0.75g/$m^2$ in said DTR-element.

**7.** A method according to claim 6 wherein the ratio of the total amount expressed by weight of said developing agent(s) of the p-dihydroxybenzene type to the total amount expressed by weight of said developing agent(s) of the 1-phenyl-3-pyrazolidinone type is comprised between 2.5 and 0.8.

**8.** A method according to claim 5 wherein the amount of said developing agents of the 1-phenyl-3-pyrazolidinone type is distributed between the silver halide emulsion layer and an antihalation layer situated between the support and said silver halide emulsion layer.

European Patent Office

# EUROPEAN SEARCH REPORT

Application Number

EP 91 20 0518

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
| --- | --- | --- | --- |
| X | US-A-4 649 095 (O. TAKAHASHI et al.) * column 11, lines 19-24; column 12, line 64 - column 13, line 9 * | 1,2 | G 03 C 8/36<br>G 03 C 8/06<br>G 03 F 7/07 |
| A | GB-A-2 081 465 (KONISHIROKU) * page 7, lines 38-54; page 8, lines 14-16 * | 3-8 | |
| A | GB-A-1 241 662 (AGFA-GEVAERT) * pages 8,9, example 4 * | 5-8 | |
| A | EP-A-0 398 435 (AGFA-GEVAERT) * page 2, lines 35-39; page 11, lines 12-45 * | 1-3 | |
| | | | TECHNICAL FIELDS SEARCHED (Int. Cl.5) |
| | | | G 03 C 8/00<br>G 03 F 7/07 |

The present search report has been drawn up for all claims

| Place of search | Date of completion of the search | Examiner |
| --- | --- | --- |
| BERLIN | 09-10-1991 | STOCK H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document